## Europäisches Patentamt
## European Patent Office
## Office européen des brevets

(19)

(11) Numéro de publication: **0 124 940**

**B1**

(12)

# FASCICULE DE BREVET EUROPÉEN

(45) Date de publication du fascicule du brevet:
**13.01.88**

(51) Int. Cl.⁴: **H 03 D 3/24**

(21) Numéro de dépôt: **84200627.2**

(22) Date de dépôt: **03.05.84**

(54) Boucle à verrouillage de phase et dispositif de démodulation de signaux modulés en fréquence comprenant une telle boucle.

(30) Priorité: **06.05.83 FR 8307586**

(43) Date de publication de la demande:
**14.11.84 Bulletin 84/46**

(45) Mention de la délivrance du brevet:
**13.01.88 Bulletin 88/2**

(84) Etats contractants désignés:
**DE FR GB**

(56) Documents cité:
**EP-A-0 057 480**
**US-A-3 676 785**
**US-A-3 778 728**
**US-A-3 821 470**

**9TH EUROPEAN MICROWAVE CONFERENCE,**
**conference proceedings 1, 17-20 septembre 1979,**
**BRIGHTON (US) R.S. PENGELLY: "Broad and**
**narrow-band frequency discriminators using dual**
**gate GaAs field effect transistors", pages 326-330**

(73) Titulaire: **PORTENSEIGNE, 50 rue Roger Salengro**
**Péripole 114, F-94126 Fontenay- sous- Boix Cédex**
**(FR)**

(84) Etats contractants désignés: **FR**

(73) Titulaire: **N.V. Philips' Gloeilampenfabrieken,**
**Groenewoudseweg 1, NL- 5621 BA Eindhoven (NL)**

(84) Etats contractants désignés: **DE GB**

(72) Inventeur: **Horvat, Philippe Nicolas, Société Civile**
**S.P.I.D. 209 rue de l'Université, F-75007 Paris (FR)**
Inventeur: **Gris, Joel Pierre, Société Civilé S.P.I.D.**
**209 rue de l'Université, F-75007 Paris (FR)**

(74) Mandataire: **Landousy, Christian, Société Civile**
**S.P.I.D. 209, Rue de l'Université, F-75007 Paris**
**(FR)**

EP 0 124 940 B1

## Description

La présente invention concerne une nouvelle structure de boucle à verrouillage de phase composée au moins d'un comparateur de phase et d'un oscillateur et comprenant un transistor à effet de champ à double grille dont les deux grilles constituent les deux entrées de comparaison de phase de la boucle, ainsi que l'application d'une telle boucle à la réalisation d'un dispositif de démodulation de signaux modulés en fréquence.

Les émissions de télévision qui seront dans les années à venir retransmises par l'intermédiaire de satellites géostationnaires seront modulées en fréquence, avec des excursions nominales de porteuse importantes, de l'ordre de 13,5 mégahertz. Les installations de réception individuelles et collectives correspondantes seront par conséquent équipées de dispositifs de démodulation de signaux modulés en fréquence qui, en tant que produits dits grand public, doivent être peu coûteux et donc simples.

Le document "9th European Microwave Conference", Conference Proceedings 1, 17-20, septembre 1979, pages 326-330, de R.S. Pengelly, intitulé: "Broad and narrow-band frequency discriminators using dual-gate GaAs field-effect transistors", décrit un transistor à effet de champ à double grille utilisé en discriminateur de phase pouvant même être utilisé dans une boucle à verrouillage de phase. Cependant, dans ces applications, il n'est pas mentionné de possibilité de monter ce transistor en oscillateur, et cet élément actif doit donc être prévu de façon externe.

Le but de l'invention est de proposer une structure à boucle à un seul élément actif, permettant une utilisation à très haute fréquence.

A cet effet l'invention concerne une boucle à verrouillage de phase telle que définie dans le préambule et caractérisée en ce que ledit transistor à effet de champ est monté en oscillateur à circuit de réaction de type Hartley et en ce que son drain est relié, éventuellement par l'intermédiaire d'un filtre passe-bas de boucle, à l'entrée dudit circuit de réaction, lui-même relié à un circuit d'accord de l'oscillateur.

La structure ainsi proposée cumule de façon simple toutes les fonctions d'une boucle à verrouillage de phase classique, puisque l'oscillateur joue aussi le rôle de mélangeur des deux entrées de grille, pour la génération, sur le drain, d'un signal d'erreur de phase qui est renvoyé en contre-réaction vers le circuit d'accord de l'oscillateur.

L'avantage d'un tel regroupement de fonctions est essentiellement de permettre une utilisation à très haute fréquence, les connexions pouvant être très courtes.

Les particularités et avantages de l'invention apparaîtront maintenant de façon plus précise dans la description qui suit et dans les dessins annexés, donnés à titre d'exemples non limitatifs et dans lesquels :

- la figure 1 est un exemple de dispositif de démodulation utilisant une boucle à verrouillage de phase conforme à l'invention ;
- les figures 2a à 2c montrent trois variantes de realisation du circuit d'accord de l'oscillateur de cette boucle.

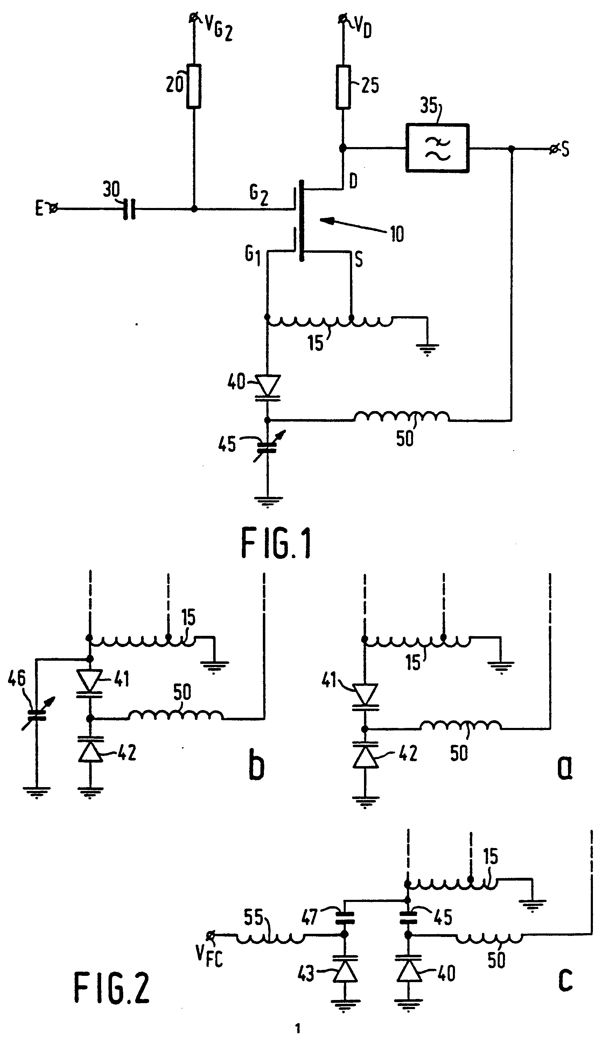

Le dispositifs décrit en reference à la figure 1 comprend un transistor 10 à effet de champ à double grille monté en oscillateur à circuit de réaction de type Hartley, ici à drain commun et à prise intermédiaire sur une inductance 15 ; cette inductance est elle-même reliée, par ses extrémités, à la grille $G_1$ et à la masse et, par la prise intermédiaire, à la source S du transistor à effet de champ. La grille $G_1$ et la source S sont donc polarisées par liaison à la masse par l'intermédiaire de l'inductance 15, tandis que la grille $G_2$ est reliée pour sa polarisation à une tension $V_{G_2}$ par l'intermédiaire d'une résistance 20 et que le point de fonctionnement du drain D est fixé par une tension $V_D$ par l'intermédiaire d'une résistance 25.

Les grilles $G_2$ et $G_1$ reçoivent l'une la porteuse à démoduler (connexion E), par l'intermédiaire d'un condensateur de découplage 30, et l'autre le signal de l'oscillateur, tandis que le drain D est relié (ici par l'intermédiaire d'un filtre passe-bas de boucle 35 destiné d'une part à interdire à la fréquence des signaux arrivant sur la grille $G_2$ d'être également présente en sortie et d'autre part à éviter l'amortissement du circuit d'accord par une impédance trop faible) d'une part à l'entrée d'un circuit de réaction et d'autre part à la sortie S du dispositif, cette sortie délivrant les signaux démodulés. Dans l'exemple décrit, le circuit d'accord de l'oscillateur comprend en série, entre la grille $G_1$ et la masse, une diode varicap 40 (anode reliée à $G_1$) et un condensateur variable 45 de centrage de l'oscillateur par ajustage de la fréquence centrale (ou d'abord le condensateur puis la diode, l'anode de celle-ci étant alors reliée à la masse), et le circuit de réaction comprend une inductance 50 prélevant le signal de sortie du dispositif pour le réintroduire dans le circuit d'accord, sur la borne intermédiaire de celui-ci, entre la diode 40 et le condensateur 45.

Le fonctionnement de la structure qui vient d'être décrite est le suivant. L'unique élément actif de cette structure, le transistor 10, cumulant toutes les fonctions d'une boucle à verrouillage de phase, assure d'abord une comparaison de phase entre le signal présent sur la grille $G_2$ (la porteuse à démoduler) et le signal de l'oscillateur local, fourni sur la grille $G_1$. Ces signaux respectivement incident et de réaction provoquent après amplification l'apparition, sur le drain D, d'un signal d'erreur de phase qui, après traversée du filtre 35, est fourni au circuit d'accord pour assurer une contre-réaction en phase du dispositif.

Les performances d'un tel dispositif sont extrêmement satisfaisantes. Avec le dispositif de démodulation qui à été réalisé, la fréquence centrale étant de 440 mégahertz et le niveau du signal incident 0 dBm, l'excursion de la porteuse a été importante (plage de verrouillage : environ 50 mégahertz) et la bande passante du signal démodulé pouvait s'élever jusqu'à 50 mégahertz également. La linéarité de démodulation, qui dépend du point de fonctionnement du transistor 10 et du choix des éléments réactifs notamment, peut être meilleure que 1 %. Ces résultats ont ici été obtenus avec, comme élément actif, un transistor à effet de champ à double grille référencé BF 905 au catalogue de la société Texas Instruments ou BF 966 à celui de la société RTC et, pour les autres éléments, les valeurs suivantes de préférence : $V_{G_2} = 4$ volts, $V_D = 12$ volts, résistance $20 = 200$ ohms, résistance $25 = 680$ ohms, capacité du condensateur variable $45 = $ de 2 à 10 picofarads ; la diode 40 est référencée OF 555 au catalogue de la société RTC, et l'inductance 15 est réalisée en ligne imprimée d'une longueur d'environ 3 centimètres.

Bien entendu, la présente invention n'est pas limitée à l'exemple d'application décrit ci-dessus, à partir duquel des variantes peuvent être proposées sans pour cela sortir du cadre de l'invention. La nouvelle structure proposée est en effet utilisable à d'autres fréquences, et également dans toutes les applications traditionnelles ou possibles des boucles à verrouillage de phase telles que restitution de porteuse dans le cas d'une modulation d'amplitude, verrouillage sur une harmonique ou une sous-harmonique, modulation de phase par superposition d'un signal modulant à la tension du drain (la porteuse étant injectée sur la grille $G_2$) etc... Par ailleurs, tel que décrit, le circuit d'accord de l'oscillateur comprend la diode 40 et le condensateur 45, mais il peut être composé difféfemment : de deux diodes varicap 41 et 42 comme sur la figure 2a, de ces deux diodes et d'un condensateur 46 en parallèle sur elles comme sur la figure 2b (les anodes des diodes étant reliées à $G_1$ et à la masse), ou encore, comme le montre la figure 2c, d'un circuit de commande de la fréquence centrale de fonctionnement placé en parallèle sur le circuit d'accord et comprenant lui aussi un condensateur 47 et une diode 43 dont la borne commune est reliée à une inductance 55 elle-même reliée à une tension de polarisation $V_{FC}$.

## Revendications

1. Boucle à verrouillage de phase composée au moins d'un comparateur de phase et d'un oscillateur et comprenant un transistor (10) à effet de champ à double grille dont les deux grilles ($G_1$, $G_2$) constituent les deux entrées de comparaison de phase de la boucle, caractérisée en ce que ledit transistor à effet de champ est monté en oscillateur à circuit de réaction (50) de type Hartley et en ce que son drain (D) est relié, éventuellement par l'intermédiaire d'un filtre passe-bas de boucle (35), à l'entrée dudit circuit de réaction, lui-même relié à un circuit d'accord de l'oscillateur.

2. Application de la boucle à verrouillage de phase selon la revendication 1 à la réalisation d'un dispositif de démodulation de signaux modulés en fréquence, caractérisée en ce que les grilles ($G_2$, $G_1$) du transistor (10) à effet de champ reçoivent l'une la porteuse à démoduler et l'autre la sortie du circuit d'accord (40, 45) de l'oscillateur et en ce que son drain (D) est relié, éventuellement par l'intermédiaire du filtre de boucle (35), d'une part à l'entrée du circuit de réaction (50) et d'autre part à la sortie du dispositif pour délivrer les signaux démodulés.

3. Dispositif selon la revendication 2, caractérisé en ce que le circuit d'accord comprend une diode (40) et un condensateur (45).

4. Dispositif selon la revendication 2, caractérisé en ce que le circuit d'accord comprend deux diodes varicap (47) et (42).

5. Dispositif selon la revendication 4, caractérisé en ce qu'il comprend un condensateur de réglage (46) placé en parallèle sur les diodes.

6. Dispositif selon l'une des revendications 2 à 5, caractérisé en ce qu'il comprend, en parallèle sur le circuit d'accord, un circuit (43, 47, 55) de commande de la fréquence centrale de fonctionnement.

## Patentansprüche

1. Phasenregelschleife, die aus mindestens einer Phasenvergleichsschaltung und einem Oszillator besteht und einen Feldeffekttransistor (10) mit doppelter Gate-Elektrode aufweist, wobei die zwei Gate-Elektroden ($G_1$, $G_2$) die zwei Phasenvergleichseingänge der Schleife bilden, dadurch gekennzeichnet, dass der genannte Feldeffekttransistor als Oszillator mit einer Rückkopplingsschaltung vom Hartley-Typ geschaltet ist und dass die Drain-Elektrode (D) gegebenenfalls über ein Tiefpass-Schleifenfilter (35) mit dem Eingang der genannten Rückkopplungsschaltung verbunden ist, die an sich mit einem Abstimmkreis des Oszillators verbunden ist.

2. Die Vervendung der Phasenregelschleife nach Anspruch 1 zur Verwirklichung einer Schaltungsanordnung zum Demodulieren frequenzmodulierter Signale, dadurch gekennzeichnet, dass die Gate-Elektroden ($G_2$, $G_1$) des Feldeffekttransistors (10) den zu demodulierenden Träger bzw. das Ausgangssignal des Abstimmkreises (40, 45) des Oszillators erhalten und dass die Drain-Elektrode (D), gegebenenfalls über das Schleifenfilter (35) einerseits mit dem Eingang der Rückkopplungsschaltung (50) und andererseits mit dem Ausgang der Schaltungsanordnung zum Liefern der demodulierten Signale verbunden ist.

3. Schaltungsanordnung nach Anspruch 2, dadurch gekennzeichnet, dass der Abstimmkreis eine Diode (40) und einen Kondensator (45) aufweist.

4. Schaltungsanordnung nach Anspruch 2, dadurch gekennzeichnet, dass der Abstimmkreis zwei Varikap-Dioden (41) und (42) aufweist.

5. Schaltungsanordnung nach Anspruch 4, dadurch gekenzeichnet, dass sie einen zu den Dioden Parallelgeschalteten Regelkondensator (46) aufweist.

6. Schaltungsanordnung nach einem der Ansprüche 2 bis 5, dadurch gekennzeichnet, dass sie parallel zu dem Abstimmkreis einen Steuerkreis (43, 47, 55) für die zentrale Betriebsfrequenz aufweist.

## Claims

1. A phase-locked loop composed of at least a phase comparator and an oscillator and comprising a dual-gate field-effect transistor (10) whose two gates ($G_1$, $G_2$) constitute the two phase comparison inputs of the loop, characterized in that the said field-effect transistor is arranged in the feedback oscillator (50) of the Hartley type and in that its drain (D) is coupled, optionally via a low-pass loop filter (35) to the input of said feedback circuit, which feedback circuit is connected to a tuning circuit of the oscillator.

2. Application of the phase-locked loop as claimed in Claim 1 for realizing a device for demodulating frequency-modulated signals, characterized in that one of the gates ($G_1$, $G_2$) of the field-effect transistor (10) receives the carrier to be demodulated and the other gate receives the output signal from the oscillator tuning circuit (40, 45) and in that the drain (D) is coupled, optionally via the loop filter (35) to the input of the feedback circuit (50), and also to the output of the device for supplying the demodulated signals.

3. A device as claimed in Claim 2, characterized in that the tuning circuit comprises a diode (40) and a capacitor (45).

4. A device as claimed in Claim 2, characterized in that the tuning circuit comprises two varicap diodes (41) and (42).

5. A device as claimed in Claim 4, charcterized in that it comprises a control capacitor (46) arranged in parallel with the diodes.

6. A device as claimed in any of the Claims 2 to 5, characterized in that it comprises a circuit (43, 47, 55) for controlling the central operating frequency, arranged in parallel with the tuning circuit.

FIG.1

FIG.2